(19) Europäisches Patentamt
European Patent Office
Office européen des brevets

(11) Publication number: **0 297 052 A2**

(12) **EUROPEAN PATENT APPLICATION**

(21) Application number: **88810422.1**

(22) Date of filing: **20.06.88**

(51) Int. Cl.[4]: **G 03 F 7/10**
G 03 C 1/68

(30) Priority: **25.06.87 GB 8714865**

(43) Date of publication of application:
**28.12.88 Bulletin 88/52**

(84) Designated Contracting States:
**BE CH DE FR GB IT LI NL**

(71) Applicant: **CIBA-GEIGY AG**
**Klybeckstrasse 141**
**CH-4002 Basel (CH)**

(72) Inventor: **Harris, Philip James**
**44 Oak Road**
**Cheadle Stockport Cheshire SK8 1EJ (GB)**

(54) **Photopolymerisable composition.**

(57) A photopolymerisable composition which comprises a water-soluble non-volatile ethylenically unsaturated monomer and a photopolymerisation initiator which comprises a compound having at least one tertiary amine group and as a dye sensitizer a compound of the formula

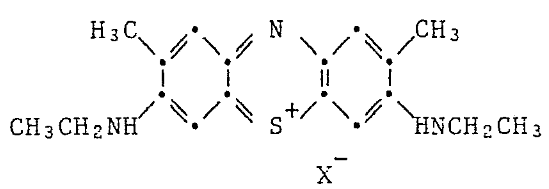

where X is an anion.

EP 0 297 052 A2

## Description

### Photopolymerisable Composition

This invention relates to novel photopolymerisable compositions and in particular to photopolymerisable compositions which are of use in the production of volume holograms.

A large number of photopolymerisable systems are known wherein under the action of light a polymer is formed from a monomer or a mixture of monomers. Photopolymerisable materials have been used to provide raised images and in the production of photoresists.

A review of photopolymerisable processes is set forth in Chapter X of 'Imaging Systems' by Jacobson and Jacobson, John Wiley and Sons N.Y., pages 181-222 (1976). Dye-sensitized photopolymerisation is also discussed in this chapter.

In the well-known book 'Light-Sensitive Systems' by J. Kosar, John Wiley and Sons (1965) in Chapter 5 there are discussed various photopolymerisation processes. On pages 184-187 of this book there is a section on photo reducible dyes. It states on these pages that it has been well-known for many years that certain dyes will in the presence of electron donors (i.e. reducing agents) undergo reduction to their leuco form when illuminated by light. The article states that the reduced dye then reacts with ambient oxygen to produce free radicals which can initiate polymerisation of a polymerisable monomer. However it is now thought that no reaction with oxygen is required to produce free radicals.

Methylene Blue has been widely used as the sensitising dye in such compositions but we have found that a derivative of methylene blue gives an unexpectedly higher sensitivity to photopolymerisable compositions which comprise it.

Therefore according to the present invention there is provided a photopolymerisable composition which comprises a water-soluble non-volatile ethylenically unsaturated monomer, a photopolymerisation initiator which comprises a compound having at least one tertiary amine group and as a dye sentisizer a compound of the formula

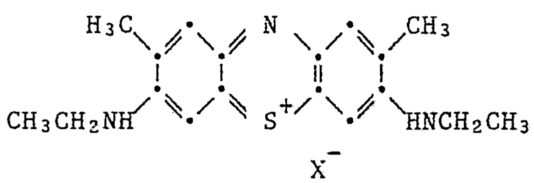

where X is an anion.

Preferably X is 1/2 $ZnCl_2$.

The compound of formula (1) as known commercially as New Methylene Blue and herewith is referred to as NMB.

As is shown hereinafter NMB is a much more efficient sensitizer in photopolymerisable compositions than Methylene Blue (MB) and is a much more efficient sentisizer than could have been predicted by comparing certain of its physical characteristics with related dyes for example Methylene Blue, Azure A and Azure B.

For example the increase in sensitivity would not be anticipated on the basis of $\lambda$ max and $\varepsilon$ max values, as the other dyes would be expected to be comparable in effect as shown in Table 1.

TABLE 1

| DYE | $\lambda$ MAX (nm) | $\varepsilon$ MAX/($mol^{-1}dm^3cm^{-1}$) |
|---|---|---|
| AZURE A | 628 | $5.32 \times 10^4$ |
| AZURE B | 640 | $9.13 \times 10^4$ |
| METHYLENE BLUE | 654 | $1.32 \times 10^5$ |
| NEW METHYLENE BLUE | 627 | $8.65 \times 10^4$ |

The preferred ethylenically unsaturated monomers for use in the present invention are the metal salts of acrylic or methacrylic acids. The preferred salts are lithium, sodium, potassium, barium, lead, zinc or magnesium acrylate. The most preferred salts are lithium or zinc acrylate.

A mixture of the metal acrylates may be used or mixtures of a metal acrylate and another ethylenically unsaturated monomer such as acrylamide, methacrylamide, N-hydroxymethylacrylamide, methylenebisacrylamide. Also esters of acrylic and methacrylic acids having low volatility may also be used, for example pentaerythritol, tetraacrylate, trimethylolpropane trimethacrylate and polybutanediol diacrylate.

The compound which comprises at least one tertiary nitrogen group may be any such compound which has been used in the past in photopolymerisable compositions such as triethanolamine. Preferably however the compound is a hydroxyalkylamine derivative of the general formula

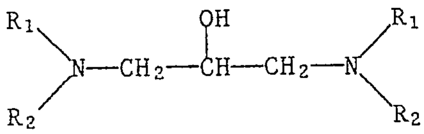

(2)

where $R_1$ is hydrogen or, an alkyl group having 1 to 4 carbon atoms or a group of the formula

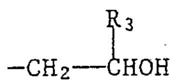

(3)

where $R_3$ is hydrogen or an alkyl group having 1 to 4 carbon atoms and $R_2$ is also a group of formula (3).

The preferred compounds of formula (1) are compound A of the formula

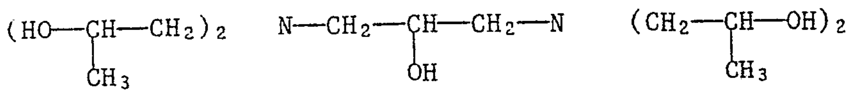

,

Compound B of the formula

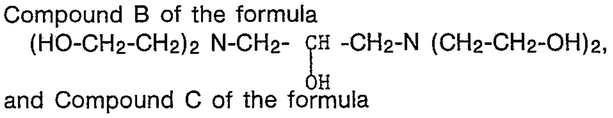

and Compound C of the formula

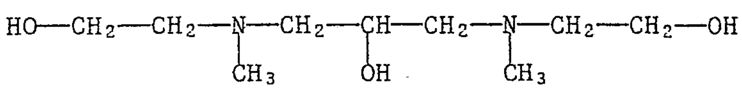

.

Another very useful compound is a polymer of the general formula

(4)

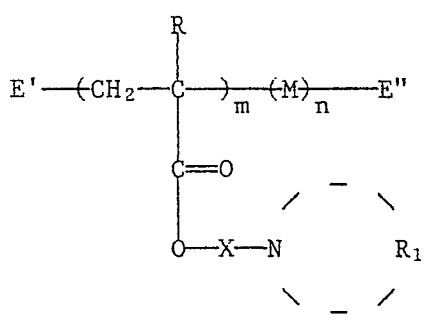

where R is a hydrogen atom or a lower alkyl group having 1 to 4 carbon atoms, X is an alkylene chain having 2 to 4 carbon atoms in the chain, $R_1$ represents the atoms necessary to complete an optionally substituted 5- or

6-membered saturated nitrogen-containing ring which may contain a further heteroatom and M represents the residue of at least one ethylenically unsaturated comonomer, E′ and E″ are end-groups as defined below, m and n are mole-fractions of monomer units, with m being 0.50 to 1.00 and n being 0 to 0.50.

Usually the molecular weight of the polymer is from 5000 to 100,000.

Preferably the polymer is a homopolymer that is to say no M residues are present.

Preferably R is $CH_3$ or hydrogen.

Preferably X is $(CH_2)_2$.

Preferably 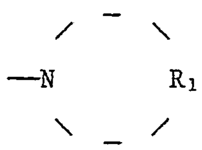 represents 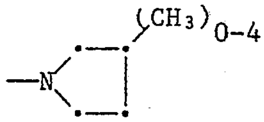

or

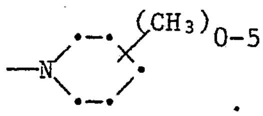

Other substitution in the heterocyclic ring may be other lower alkyl having up to 4 carbon atoms and hydroxyalkyl groups for example hydromethyl.

Particularly useful polymers of formula are homopolymers of formula

(5) 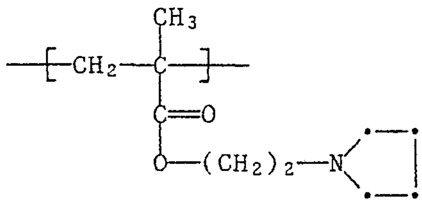 ,

of formula

(6) 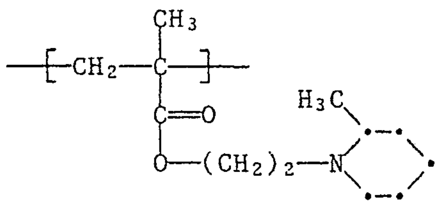 ,

of formula

(7) 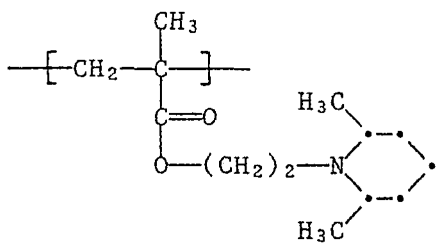

and of formula

(8) 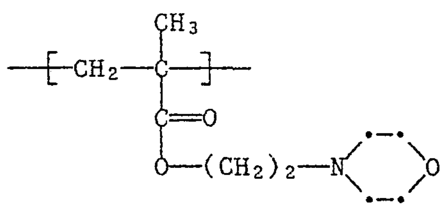 .

Copolymers which comprise at least two monomers as shown in formulae (5) to (8) may also be used, as well as mixtures of the homopolymers or copolymers.

Suitable residues of monomers M which may be present in the polymer of formula (4) include N-vinyl pyrrolidone, acrylamide, vinylpyridine or vinyl esters.

With reference to the E′ and E″ end-groups, as is well-known to anyone experienced in the art, the end-groups of polymer molecules formed by free radical initiation are generally incapable of determination with any degree of certainty, however it may be expected that at least one of the end-groups may either be an initiator residue or a group formed by the disproportionation or chain transfer reactions during the preparation of the polymer. Initiator residues may generally include those from alkyl or aryl peroxides, azo compounds, peroxydisulphates, peresters and peroxy carbonates, and specific examples may include the radicals of the formulae

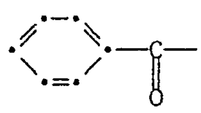 , 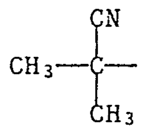 , 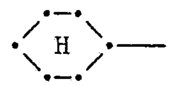 ,

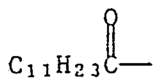 and 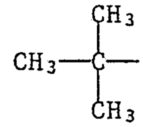 .

Further examples of commonly used initiators may be found in Polymer Handbook, Second Edition, John Wiley Publishers N.Y., 1975. Editors E.H. Immergut and J. Brandrup, Chapter II.1.

End-groups formed by disproportionation reactions may be saturated or unsaturated units from M or the initiating agent. Examples of such units may be found in Principles of Polymer Chemistry, Cornell U.P., P.J. Floy, p. 111.

It is not believed that the end-groups play any significant part in the photopolymerisation process.

According to a second feature of the present invention there is provided an assembly for the preparation of a hologram which comprises a transparent supporting base on which is coated a photopolymerisable composition as just defined which has been dispersed in a hydrophilic water swellable binder.

A particularly useful binder is gelatin. Other useful binders which may be used alone or in admixture or preferably in admixture with gelatin include albumin, casein, cellulose derivatives such as hydroxyethyl cellulose and carboxymethyl cellulose, polyvinyl alcohol, polyvinyl pyrrolidone and polyacrylamide. Preferably at least 25 % by weight of gelatin is present in the binder.

Other components which may be optionally present in the assembly for the preparation of a hologram are for example surfactants such as alkyl sulphates, alkylaryl sulphonates, polyalkoxylated phenols and other surfactants well-known in the literature. Inhibitors may be present to ensure dark stability of the coated compositions, examples being hydroquinone, p-methoxyphenol, or t-butyl catechol.

Humectants may be present in order to allow better control over the moisture content of the coated layer during the necessary pre-exposure moisture activation step and these may include ethylene glycol, glycerol, trimethylolpropane and other polyhydroxy compounds as well as other compounds known in the art.

The photopolymerisable compositions of the present invention may be dispersed in an aqueous binder solution and then coated by the conventional techniques well-known to the photographic industry by doctor bar, slot, cascade, curtain and dip, and the coated layers dried by normal (hot) air methods.

The coated assemblies may be stored essentially unchanged for several months under low moisture, low temperature conditions. Before exposure the coatings are activated by bringing them into a controlled humidity environment, whereupon sufficient moisture is adsorbed to enable the photopolymerisation to occur.

Exposure may be to white light or light of selected wavelengths, and the compositions of the present invention are especially suitable for exposure to lasers. The exposed assemblies may be processed by the well-known sequence of swelling in a hydrophilic bath (e.g. pure water) followed by shrinking and dehydration in a water-miscible solvent.

The hydrophilic bath may contain, if desired, additional components, for example compounds which bring about an increase in the wavelength of the processed hologram, and compounds which lead to improved image stability. The dehydrated, exposed coatings may then be dried with warm air and laminated, if required, to produce moisture stable holographic images

The following Examples will serve to illustrate the invention.

## Example 1

### Preparation of a hologram from photopolymerisable composition of the present invention

1. Preparation of polypyrrolidinoethylmethacrylate of formula (5).

Pyrrolidinoethylmethacrylate (15 g), azobis-cyanopentanoic acid (0.30 g) and ethanol (85 g) were heated under nitrogen at 60°C for 20 hours. The polymer (I) was isolated by precipitation into ice cold water, filtering and drying in vacuo. There was thus obtained 9 g (60 % conversion) of a pale yellow glass (Tg approximately 50°C), whose weight average molar mass (determined by gel permeation chromatography) was 14500.

2. Preparation of photosensitive assembly using the homopolymer of formula (5).

A solution of lithium acrylate was first prepared by adding freshly distilled acrylic acid (1.25 g) to a cooled solution of lithium hydroxide monohydrate (0.67 g) in water (3.50 g). To this solution was added 0.003 g p-methoxyphenol as inhibitor. This solution was then mixed with 3.76 g of a 30 % weight/weight aqueous solution of polyvinyl pyrrolidone (40,000 MW) and gelatin (in equal weight proportions). Finally in the dark, the above was mixed with a solution comprising (5), 0.24 g, New Methylene Blue (3 mg in 0.5 g water) with propan-2-ol (2.7 g).

Within 1 hour the solution was coated under green light on to thin polyester subbed photographic base strips. The coating had a 'wet' thickness of 100 μm. The coatings were allowed to dry for 30 minutes under a stream of air. At this stage a supercoat of 5 % wt/wt aqueous gelatin solution was applied and again allowed to dry. Coatings were stored at 23 % RH and 19°C until required.

3. Preparation of a hologram from the above photosensitive member

A 25 mW HeNe laser operating at 633 nm was used for holographic exposures. The assembly used is depicted in the attached figure.

In the figure the numbers designate as follows:

1. 25 mW HeNe laser
2. x 10 microscope objective (25 μm pinhole)
3. Plano-convex lens (focal length 300 mm)
4. Surface silvered mirror
5. Photosensitive member
6. Spatial filters
7. Object
8. Vibration isolated table.

A Denisyuk mode was employed for exposure, with the object 7 (a polished metal disc) approximately 1 mm beneath the photosensitive member 5.

Coated assemblies were first placed in a humidifying atmosphere at 65 % RH for 1 hour prior to exposure. Laser Exposures of 60 and 300 seconds were given.

The exposed coatings were processed at 20°C by placing them in water for 15 seconds followed by propan-2-ol for 30 seconds, then dried in a stream of cold air followed by a stream of warm air for 1 minute.

Bright, green holograms were produced. For example, a hologram prepared at 300 seconds exposure gave a holographic component reflecting 11 % of incident light at peak value of 580 nm. The bandwidth at half peak height was from 510 to 650 nm. At 60 seconds exposure the haze levels were somewhat greater than at 300 seconds exposure. The processed holograms were laminated with an optically clear self adhesive polyester film. The laminated holograms exhibited no change in replay wavelength or brightness over a six month storage period.

Example 2

Comparison of NMB with other dyes.

Four more photosensitive assemblies were prepared as in Example 1.

One containing NMB was prepared exactly as in Example 1.

In a second assembly 3 mg in 0.5 g water of Methylene Blue itself was used as sensitizer. In a third assembly 3 mg in 0.5 g water of Azure B was used as sensitizer. In a fourth assembly 3 mg in 0.5 g water of Azure B was used as sensitizer.

Samples of the coatings were then humified to a range of controlled atmospheres, between 35 and 75 % RH. The coated samples were then exposed to a white light, (tungsten 75 W reflector), mounted at a distance of 20 cm. A thermocouple, placed in close contact with the emulsion layer was used to record the temperature increase associated with the photopolymerisation. The temperature increase at each test sample at each RH value was recorded as a function of time.

The following table indicates the exotherms and rate of exothermic reaction on exposure of the coatings at 65 % RH (optimum value), for the four dyes.

| Sensitizer Dye | T (°C) | dT/dt (°C/s) |
|---|---|---|
| AZURE A | 3 - 4 | 0.20 |
| AZURE B | 4 - 5 | 0.19 |
| METHYLENE BLUE | 7 - 9 | 0.28 |
| NEW METHYLENE BLUE | 12 - 15 | 0.67 |

T (°C) is the exotherm observed upon exposure to light, measured in degrees centigrade.

dT/dt (°C/s) is the rate of exothermic reaction, measured in degrees centigrade per second.

From this Table it will be seen that NMB exhibits the greatest photoinitiation effect.

Example 3

Further comparison examples

To further demonstrate the increase in photopolymerisation efficiency, achieved with New Methylene Blue as the dye sensitizer, a series of photopolymerisation initiators were coated according to the previous formulation set out in Example 1.

A series of methyl substituted piperidine polymers were employed as the photoinitiators. The results (TABLE 3) consistently show that New Methylene Blue has an increased sensitivity leading to greater photopolymerisation efficiency compared with Methylene Blue.

The substituted piperidine polymers employed had the following structure and are polymers of formula (4) as hereinbefore set forth

(4) 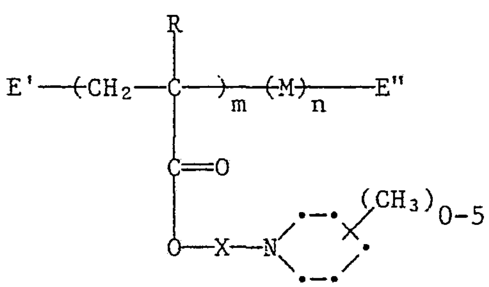

TABLE 3

| SUBSTITUENT ON THE PIPERIDINE RING IN THE POLYMER | SENSITIZER DYE | T. (°C) | dT/dt (°C/s) |
|---|---|---|---|
| 2 - METHYL PIPERIDINE | MB<br>NMB | 8 - 9<br>12 - 13 | 0.32<br>0.80 |
| 2,6-DIMETHYL PIPERIDINE | MB<br>NMB | 4 - 5<br>10 - 11 | 0.19<br>0.70 |
| 4 - METHYL PIPERIDINE | MB<br>NMB | 3 - 4<br>4 - 5 | 0.11<br>0.15 |
| 3,5-DIMETHYL PIPERIDINE | MB<br>NMB | 3 - 4<br>6 - 7 | 0.14<br>0.28 |

**Claims**

1. A photopolymerisable composition which comprises a water-soluble non-volatile ethylenically unsaturated monomer and a photopolymerisation initiator which comprises a compound having at least one tertiary amine group and as a dye sensitizer a compound of the formula

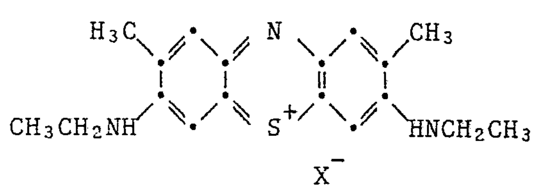

(1)

where X is an anion.

2. A photopolymerisable composition according to claim 1 where X in formula 1 is 1/2 $ZnCl_2$.

3. A photopolymerisable composition according to claim 2 wherein the ethylenically unsaturated monomer is a metal salt of acrylic or methacrylic acid.

4. A photopolymerisable composition according to claim 3 wherein the ethylenically unsaturated monomer is lithium or zinc acrylate

5. A photopolymerisable composition according to claim 1 wherein the dye having a tertiary amine group is a hydroxyalkylamine derivative of formula

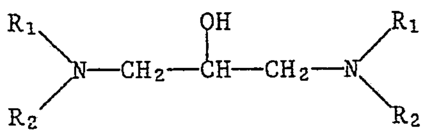

(2)

where $R_1$ is hydrogen or, an alkyl group having 1 to 4 carbon atoms or a group of the formula

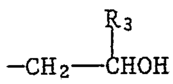

(3)

where $R_3$ is hydrogen or an alkyl group having 1 to 4 carbon atoms and $R_2$ is also a group of formula (3) or a polymer of formula

(4)

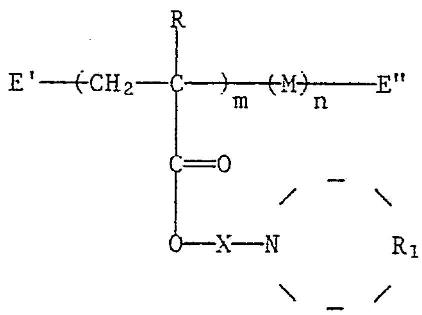

where R is a hydrogen atom or a lower alkyl group having 1 to 4 carbon atoms, X is an alkylene chain having 2 to 4 carbon atoms in the chain, $R_1$ represents the atoms necessary to complete an optionally substituted 5- or 6-membered saturated nitrogen-containing ring which may contain a further heteroatom and M represents the residue of at least one ethylenically unsaturated comonomer, E′ and E″ are end-groups as defined below, m and n are mole-fractions of monomer units, with m being 0.50 to 1.00 and n being 0 to 0.50.

6. An assembly for the preparation of a hologram which comprises a transparent supporting base on which is coated a polymerisable composition as claimed in claim 1 which has been dispersed in a hydrophilic water-swellable binder.

7. An assembly according to claim 6 wherein the hydrophilic water-swellable binder is gelatin or a binder which comprises at least 25 % by weight of gelatin.

8. A process for the preparation of a hologram which comprises holographically exposing an assembly as claimed in claim 6 and then processing the assembly.

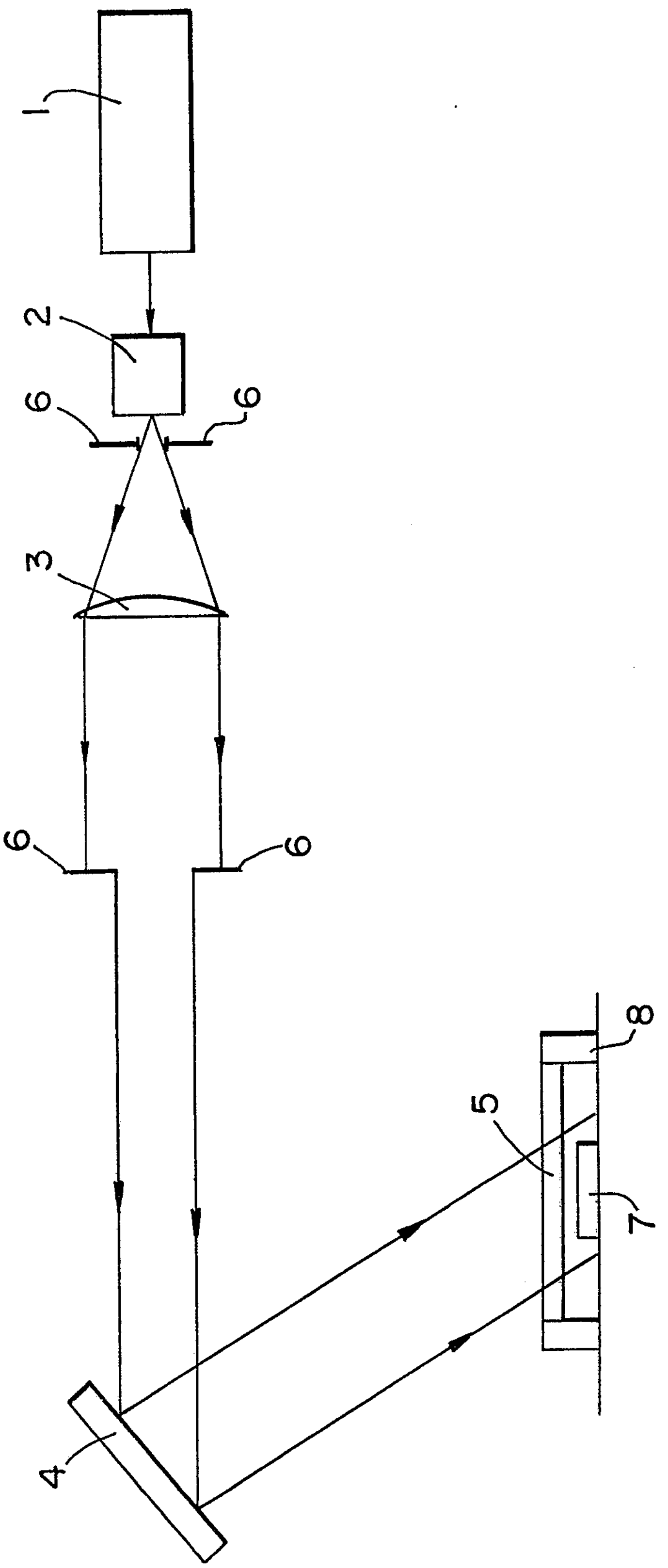
1
2
6
6
3
6
6
8
5
7
4